(19) **Europäisches Patentamt / European Patent Office / Office européen des brevets**

(11) **EP 2 225 572 B1**

(12) **EUROPÄISCHE PATENTSCHRIFT**

(45) Veröffentlichungstag und Bekanntmachung des Hinweises auf die Patenterteilung:
**15.02.2012 Patentblatt 2012/07**

(21) Anmeldenummer: **08865034.6**

(22) Anmeldetag: **18.12.2008**

(51) Int Cl.:
**G01R 31/36** (2006.01)

(86) Internationale Anmeldenummer:
**PCT/EP2008/067841**

(87) Internationale Veröffentlichungsnummer:
**WO 2009/080686 (02.07.2009 Gazette 2009/27)**

(54) **ÜBERWACHUNGSSCHALTUNG FÜR EINEN ENERGIESPEICHER UND VERFAHREN ZUM ÜBERWACHEN EINES ENERGIESPEICHERS**

MONITOR CIRCUIT FOR AN ENERGY STORAGE AND METHOD FOR MONITORING AN ENERGY STORAGE

CIRCUIT DE CONTRÔLE POUR UN ACCUMULATEUR D'ÉNERGIE, ET PROCÉDÉ DE CONTRÔLE D'UN ACCUMULATEUR D'ÉNERGIE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **20.12.2007 DE 102007061539**

(43) Veröffentlichungstag der Anmeldung:
**08.09.2010 Patentblatt 2010/36**

(73) Patentinhaber: **Continental Automotive GmbH 30165 Hannover (DE)**

(72) Erfinder:
• ZIMMERMANN, Uwe
  09350 Lichtenstein Ot Roedlitz (DE)
• BÜCHEL, Mathias
  93053 Regensburg (DE)
• GILCH, Markus
  85419 Mauern (DE)

(56) Entgegenhaltungen:
US-A- 5 438 270          US-A1- 2002 047 685
US-A1- 2004 199 343      US-B1- 6 329 792

**Beschreibung**

Die Erfindung betrifft eine Überwachungsschaltung für einen Energiespeicher und ein Verfahren zur Überwachung eines Energiespeichers. Eine in einem Elektrofahrzeug verwendete Batterie muss zum Betrieb des Fahrantriebs eine hohe Spannung erzeugen. Üblicherweise weist die Batterie eine Mehrzahl von Zellen auf, die jeweils eine Spannung bereitstellen und die in Reihe geschaltet sind. Die einzelnen Zellen sollten dabei gegen Überspannung geschützt sein. Deshalb in der US 2002/047685 A1 eine Überwachungsschaltung gezeigt, die die einzelnen Zellen überwacht, wobei eine Vielzahl von Spannungsmessschaltungen die Spannungen an den einzelnen Zellen misst.

Die US 6, 329 792 B1 zeigt eine Schaltung mit einem Stapel von Batteriezellen, wobei an Anschlüsse einzelner Batteriezellen eine Last dazu geschaltet werden kann.

Um die Messungen durchführen zu können, müssen Verbindungsleitungen zwischen den Zellen und den Spannungsmessschaltungen vorgesehen werden. Dabei wurde festgestellt, dass bei herkömmlichen Überwachungsschaltungen die Überspannungen nicht zuverlässig gemessen wurden, besonders wenn die Energiespeicher und die Überwachungsschaltung schon lange im Betrieb sind.

Es ist daher Aufgabe der Erfindung, eine möglichst kostengünstige Überwachungsschaltung anzugeben, mit der die Zellen eines Energiespeichers zuverlässig erkannt werden können. Es ist auch Aufgabe der Erfindung, ein Verfahren zum Überwachen von Zellen eines Energiespeichers bereitzustellen.

Diese Aufgaben werden durch den Gegenstand der unabhängigen Ansprüche gelöst. Vorteilhafte Ausgestaltungen ergeben sich aus den jeweiligen Unteransprüchen.

Erfindungsgemäß wird eine Überwachungsschaltung für einen Energiespeicher bereitgestellt. Dieser Energiespeicher weist eine Vielzahl von Zellen mit jeweils einem ersten und einem zweiten Anschluss auf. Die Zellen stellen jeweils zwischen ihrem ersten und zweiten Anschluss eine Spannung bereit. Die Zellen sind in Reihe geschaltet, wobei jeweils ein zweiter Anschluss einer ersten Zelle mit einem ersten Anschluss einer zweiten Zelle verbunden ist.

Die Überwachungsschaltung enthält mindestens zwei Spannungsmessschaltungen, die jeweils eine Spannung zwischen einem ersten Messeingang und einem zweiten Messeingang messen. Der zweite Anschluss einer ersten Spannungsmessschaltung ist mit dem ersten Messeingang einer zweiten Spannungsmessschaltung verbunden. Eine erste Verbindungsleitung dient zum Verbinden des ersten Anschlusses der ersten Zelle mit dem zweiten Messeingang der ersten Spannungsmessschaltung.

Weiterhin enthält die Überwachungsschaltung eine erste Verbindungsleitung zur Verbindung des ersten Anschlusses der ersten Zelle mit dem ersten Messeingang einer ersten Spannungsmessschaltung und eine zweite Verbindungsleitung zur Verbindung des zweiten Anschlusses der ersten Zelle mit dem zweiten Messeingang der ersten Spannungsmessschaltung.

Zusätzlich ist ein erster Belastungswiderstand vorgesehen. Der erste Belastungswiderstand ist schaltbar zwischen dem zweiten Messeingang der ersten Spannungsmessschaltung und einem ersten festen Potential vorgesehen. Dies bedeutet, dass der Belastungswiderstand entweder so geschaltet wird, dass er eine ohmsche Verbindung zwischen dem ersten Messeingang der ersten Messschaltung und dem ersten festen Potential bereitstellt, oder so geschaltet wird, dass er keine ohmsche Verbindung zwischen dem Messeingang der ersten Spannungsmessschaltung und dem ersten festen Potential bildet.

Die Überwachungsschaltung ermöglicht durch den Belastungswiderstand, Messeingänge, die nicht mehr mit den Zellen verbunden sind, auf ein anderes Potential zu bringen. Da der Belastungswiderstand den Messwert der Spannung an den Spannungsmessschaltungen beeinflusst, ist der Belastungswiderstand schaltbar vorgesehen, damit einmal mit der und einmal ohne die Belastung die Spannungen an den Zellen gemessen werden. Besonders im Fahrzeugbau sollten die Energiespeicher Jahre lang beziehungsweise Jahrzehnte lang halten. Die Energiespeicher werden üblicherweise auf einem Blech verschweißt und somit mechanisch stabil befestigt, aber die Verbindungsleitungen zwischen den Zellen und den Spannungsmessgeräten haben sich als Schwachstellen erwiesen. Wenn diese Verbindungsleitungen korrodieren oder durch mechanischen Stress brechen, konnte dies mit den herkömmlichen Überwachungsschaltungen nicht zuverlässig detektiert werden.

Eine erfindungsgemäße Überwachungsschaltung verbessert herkömmliche Überwachungsschaltungen dahingehend, dass auch Brüche in den Verbindungsleitungen nicht dazu führen, dass Zellen als gut getestet werden, obwohl an ihnen eigentlich eine Überspannung anliegt. Dadurch wird die Lebensdauer der Zellen und somit des gesamten Energiespeichers verlängert.

Vorzugsweise ist zusätzlich ein zweiter Belastungswiderstand schaltbar zwischen dem zweiten Messeingang der ersten Spannungsmessschaltung und einem zweiten festen Potential vorgesehen. Dabei kann in diesem Zusammenhang das zweite feste Potential, dasselbe oder ein anderes festes Potential als das erste feste Potential für den ersten Belastungswiderstand sein. Durch den zweiten Belastungswiderstand wird kann zusätzlich die zweite Verbindungsleitung überwacht werden.

In einer Ausführungsform weist die Spannungsmessschaltung einen Innenwiderstand zwischen ihren beiden Messeingängen auf. Dieser Innenwiderstand hat einen ohmschen Widerstand von $R_h$. Der erste Belastungswiderstand

und der zweite Belastungswiderstand haben jeweils ohmsche Widerstandswerte $R_n$ und es gilt $R_n < R_h$. Damit wird sichergestellt, dass die Belastungswiderstände die zu messenden Spannungen im Fehlerfall merklich verändern, so dass die Spannungsmessschaltung eine gebrochene Leitung auch detektiert.

Vorzugsweise werden Werte von $R_h$ und $R_n$ so gewählt, dass $R_n < 10 \cdot R_h$ gilt. Dadurch wird auch bei Zellen, deren Potentiale sehr weit von dem festen Potential entfernt sind, beispielsweise bei 300 V, das Potential bei gebrochener oder sehr hochohmiger Verbindungsleitung auf ein Niveau gebracht, das nah dem festen Potential ist.

Der erste Belastungswiderstand und der zweite Belastungswiderstand werden in einer Ausführungsform jeweils mit einer Diode in Reihe geschaltet. Diese Reihenschaltungen aus Belastungswiderstand und Diode weisen jeweils einen ersten und einen zweiten Außenanschluss auf. Weiterhin ist ein Transistor vorgesehen, der eine erste Laststrecke mit einem ersten Anschluss und einem zweiten Anschluss aufweist. Der erste Anschluss der Laststrecke des Transistors ist mit dem festen Potential verbunden, während der zweite Anschluss der Laststrecke des Transistors mit den ersten Anschlüssen der Reihenschaltungen aus Belastungswiderstand und Diode verbunden ist. Durch den Transistor werden alle Belastungswiderstände gleichzeitig mit dem festen Potential verbunden bzw. werden von diesem gemeinsam getrennt. Diese Ausführungsform hat den Vorteil, dass nur ein Transistor als Schalter vorgesehen werden muss. Die Dioden dienen dazu, dass die Ströme durch einen Belastungswiderstand nicht das Potential an einer Verbindungsleitung, die mit dem ersten Belastungswiderstand nicht verbunden ist, zu sehr beeinflusst.

In einer weiteren Ausführungsform wird ein Schalter vorgesehen, der in Reihe mit dem ersten Belastungswiderstand geschaltet ist. Die Reihenschaltung aus Schalter und erstem Widerstand ist zwischen den ersten Messanschluss der Spannungsmessschaltung und das feste Potential geschaltet ist, wobei der Schalter zyklisch an- und ausgeschaltet wird. Durch das zyklische An- und Ausschalten werden die Spannungen an den Spannungsmessschaltungen regelmäßig mit und ohne die Verbindungen zum festen Potential über den Belastungswiderstand gemessen. Dadurch wird regelmäßig überprüft, ob die Verbindungsleitungen defekt sind.

Besonders geeignet ist die Überwachungsschaltung für Zellen, die als wieder aufladbare Akkumulatoren ausgebildet sind. Solche sind besonders gegen Überspannung zu schützen, um die Lebensdauer des Energiespeichers nicht zu beeinträchtigen. Zu beachten ist, dass bei Energiespeichern mit einer Vielzahl, beispielsweise 100, von Zellen die Ausfallwahrscheinlichkeit steigt. Bei diesen ist deshalb besonders auf die Funktionalität jeder einzelnen Zelle zu achten.

Eine andere Anwendung bilden Kondensatorstapel, die zum Beispiel in Fahrzeugen zum Bereitstellen einer Spannung von beispielsweise 40 V für Hochstromverbraucher eingesetzt werden. Hier muss besonders darauf geachtet werden, dass nicht einzelne Kondensatoren durchbrechen und leiten, weil dann an den anderen Kondensatoren erhöhte Spannungen anliegen. Auch hier bewirken Brüche in den Verbindungsleitungen, dass die Spannungen an den einzelnen Kondensatoren nicht gemessen werden können.

Vorzugsweise sind das erste feste Potential und das zweite feste Potential beide auf Masse. Die Verwendung von Masse als festem Potential hat den Vorteil, dass dieses Potential in der Regel unabhängig von der Spannungserzeugung ist und somit auch bei fehlerhafter Spannungsversorgung stabil bleibt.

Weiterhin wird vorzugsweise eine dritte Verbindungsleitung zur Verbindung des zweiten Anschlusses der zweiten Zelle mit dem zweiten Messeingang der zweiten Spannungsmessschaltung und ein dritter Belastungswiderstand zur schaltbaren Verbindung zwischen dem zweiten Messeingang der zweiten Spannungsmessschaltung und einem festen Potential vorgesehen. Somit wird auch diese dritte Verbindungsleitung überwacht. Die Überwachungsschaltung kann für eine Vielzahl von Zellen ausgeweitet werden, indem jeweils pro Verbindungsleitung ein Belastungswiderstand vorgesehen wird.

Die Erfindung stellt auch ein Verfahren zur Überwachung eines Energiespeichers bereit. Der Energiespeicher weist dabei eine Vielzahl von Zellen auf, die jeweils einen ersten und einen zweiten Anschluss aufweisen und die jeweils eine Spannung zwischen ihrem ersten und zweiten Anschluss bereitstellen. Die Zellen sind in Reihe geschaltet, wobei jeweils ein zweiter Anschluss einer ersten Zelle mit einem ersten Anschluss einer zweiten Zelle verbunden ist.

In einem Schritt a) des Verfahrens wird eine erfindungsgemäße Überwachungsschaltung bereitgestellt. Der erste Belastungswiderstand wird in einem Schritt b) derart geschaltet, dass der erste Belastungswiderstand keine Verbindung zwischen dem zweiten Messeingang der ersten Spannungsmessschaltung und dem ersten festen Potential bildet.

In einem weiteren Schritt c) wird die Spannung an den Messeingängen der ersten Spannungsmessschaltung gemessen, wonach in einem Schritt d) der ersten Belastungswiderstand derart geschaltet wird, dass der erste Belastungswiderstand eine Verbindung zwischen dem zweiten Messeingang der ersten Spannungsmessschaltung und dem ersten festen Potential bildet. Anschließend wird in einem Schritt e) die Spannung an den Messeingängen der ersten Spannungsmessschaltung erneut gemessen. Nun wird gemäß einem Schritt f) die erste Messung mit der zweiten Messung verglichen.

Durch die zwei Messungen werden Brüche in der zweiten Verbindungsleitung entdeckt. Der erste Belastungswiderstand, falls er eine Verbindung zwischen dem Eingang der Spannungsmessschaltung und dem festen Potential bildet, zwingt den Knoten, der aufgrund des Defekts nicht mehr über die Verbindungsleitung versorgt wird, auf ein vorbestimmtes Potential. Dies wird von Überwachungsschaltung erkannt.

In einer Ausführungsform des Verfahrens wird im Schritt a) eine Überwachungsschaltung bereit gestellt, bei der ein zweiter Belastungswiderstand schaltbar zwischen dem erste Messeingang der ersten Spannungsmessschaltung und einem zweiten festen Potential vorgesehen ist. Vor dem Schritt c) wird ein Schritt des Schaltens vorgesehen, bei dem der zweite Belastungswiderstands derart geschaltet wird, dass der zweite Belastungswiderstand keine Verbindung zwischen dem ersten Messeingang der ersten Spannungsmessschaltung und dem zweiten festen Potential bildet.

Bei dem Schritt e) wird der zweite Belastungswiderstands derart geschaltet, dass der zweite Belastungswiderstand eine Verbindung zwischen dem ersten Messeingang der ersten Spannungsmessschaltung und dem zweiten festen Potential bildet.

Vorzugsweise wird bei dem Messen in Schritt c) und bei dem Messen in Schritt e) jeweils eine Statusinformation ausgegeben. Diese Statusinformation besagt, ob Unterspannung, Überspannung oder Normalspannung vorliegt. Im Schritt f) wird die in Schritt c) ausgegebene Statusinformation mit der in Schritt e) ausgegebenen Statusinformation verglichen. Die Verwendung der Statusinformation ermöglicht, dass der Vergleich sehr einfach durchgeführt werden kann und enthebt einen Benutzer der Frage, welche Messabweichungen noch toleriert werden sollen und welche einen Defekt anzeigen.

Die Erfindung ist in den Zeichnungen anhand eines Ausführungsbeispiels näher veranschaulicht.

Figur 1     zeigt einen Energiespeicher aus mehreren Zellen, der mit einer erfindungsgemäßen Überwachungsschaltung überwacht wird.

Figur 2     zeigt eine Überwachungsschaltung für einen fehlerfreiem Energiespeicher.

Figur 3     zeigt die gleiche Überwachungsschaltung wie in Figur 2 bei defektem Energiespeicher.

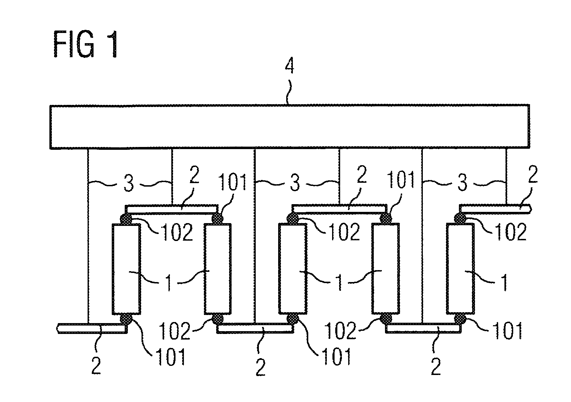

Figur 1 zeigt einen Energiespeicher, der aus einer Vielzahl von Zellen besteht. Diese Zellen stellen jeweils eine Spannung von nominal 2 V zur Verfügung und sind in Reihe geschaltet, sodass der Energiespeicher eine Spannung bereitstellt, deren nominaler Wert sich aus dem Produkt der Anzahl der Zellen und 2 V berechnet. In Figur 1 ist mit fünf Zellen nur ein Ausschnitt des Energiespeichers gezeigt.

Die Zellen weisen jeweils einen ersten Anschluss 101 und einen zweiten Anschluss 102 auf, an denen die Zellen ihre Spannung bereitstellen. Der erste Anschluss 101 einer Zelle 1 ist jeweils mit dem zweiten Anschluss 102 der benachbarten Zellen 1 über eine Kontaktierungsleitung 2 verbunden. Zur Überwachung der Spannungen an den einzelnen Zellen ist eine Überwachungsschaltung 4 vorgesehen. Verbindungsleitungen 3 greifen die Spannungen an dem Kontaktierungsleitungen 2 jeweils ab, um die Spannung zwischen benachbarten Kontaktierungsleitungen 2 zu messen.

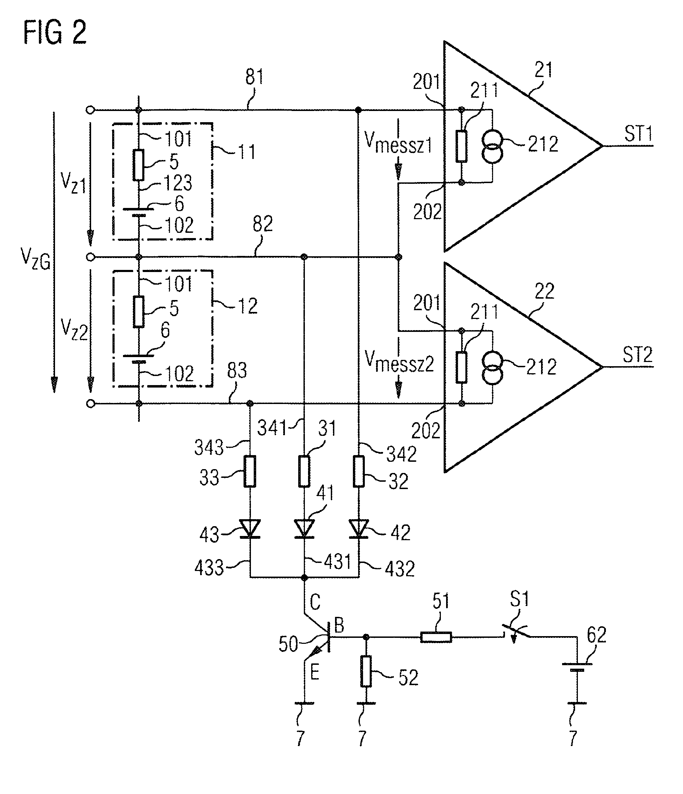

Figur 2 zeigt einen Ausschnitt aus dem Energiespeicher mit der dazugehörigen Überwachungsschaltung. Gezeigt sind die Zellen 11 und 12 des Energiespeichers, die in Reihe geschaltet sind. Die Zellen 11 und 12 enthalten jeweils eine Batterie 6 mit einem Innenwiderstand 5, dessen Widerstandswert lediglich bis einige Ohm beträgt. Der Verbindungsknoten zwischen Batterie 6 und Innenwiderstand 5 wird als Zwischenknoten 103 bezeichnet. Die Zellen weisen jeweils einen ersten Anschluss 101 und einen zweiten Anschluss 102 auf. Der zweite Anschluss 102 der ersten Zelle 11 ist mit dem ersten Anschluss 101 der zweiten Zelle 12 verbunden. Nicht gezeigt in Figur 2 sind weitere Zellen, die in Reihe geschaltet sich an den zweiten Anschluss 102 der zweiten Zelle 12 und einen ersten Anschluss 101 der ersten Zelle 11 anschließen.

Die Überwachungsschaltung enthält eine erste Spannungsmessschaltung 21 und eine zweite Spannungsmessschaltung 22, die jeweils einen ersten Messeingang 201 und einen zweiten Messeingang 202 aufweisen. Der zweite Messeingang 202 der ersten Spannungsmessschaltung 21 ist mit dem ersten Messeingang 201 der zweiten Spannungsmessschaltung 22 verbunden. Ebenfalls nicht gezeigt in Figur 2 sind weitere Spannungsmessschaltungen, die in Reihe geschaltet sich an den ersten Messeingang 201 der ersten Spannungsmessschaltung 21 und den zweiten Messeingang 202 der zweiten Spannungsmessschaltung 21 anschließen.

Der erste Anschluss 101 der ersten Zelle 11 ist über die erste Verbindungsleitung 81 mit dem ersten Messeingang 201 der ersten Spannungsmessschaltung 21 verbunden, während der zweite Anschluss 102 der ersten Zelle 11 über die Verbindungsleitung 82 mit dem zweiten Messeingang 202 der ersten Spannungsmessschaltung 21 verbunden ist.

Die Verbindungsleitung 82 bildet somit auch die Verbindung zwischen dem ersten Anschluss 101 der zweiten Zelle 12 und dem ersten Messeingang 201 der zweiten Spannungsmessschaltung 22. Der zweite Messeingang 202 der zweiten Zelle 12 ist über die Verbindungsleitung 83 mit dem zweiten Messeingang 202 der zweiten Spannungsmessschaltung 22 verbunden.

Die erste Spannungsmessschaltung 21 und die zweite Spannungsmessschaltung 22 messen jeweils die Spannung zwischen ihrem ersten Messeingang 201 und ihrem zweiten Messeingang 202. Die Spannungsmessschaltung 21 und 22 enthält hier symbolisch gezeigt einen Innenwiderstand 211 und eine Stromquelle 212, die parallel zwischen dem ersten Messeingang 201 und dem zweiten Messeingang 202 geschaltet sind. Die Spannungsmessschaltungen 21 und 22 geben an ihren Ausgängen jeweils eine Statusinformation ST1 bzw. ST2 aus. Die Statusinformationen ST1 und ST2 können jeweils drei Werte annehmen: Überspannung, Unterspannung und Normalspannung.

Mit dem ersten Messeingang 201 der zweiten Spannungsmessschaltung 22 ist über den Außenanschluss 341 eine Reihenschaltung von einem ersten Belastungswiderstand 31 und einer ersten Diode 41 verbunden. Dagegen ist der erste Messeingang 201 der ersten Spannungsmessschaltung 21 über den Außenanschluss 342 mit einer Reihenschaltung aus dem zweiten Belastungswiderstand 32 und der zweiten Diode 42 verbunden. Dergleichen ist der zweite Messeingang 202 der zweiten Spannungsmessschaltung 22 über den Außenanschluss 343 mit der Reihenschaltung aus drittem Belastungswiderstand und dritter Diode 43 verbunden.

Die Reihenschaltung aus erstem Belastungswiderstand 31 und erster Diode 41 weisen Außenanschlüsse 341 und 431 auf, während die Reihenschaltung aus zweitem Belastungswiderstand 32 und zweiter Diode 42 die Außenanschlüsse 342 und 432 und die Reihenschaltung aus drittem Belastungswiderstand 33 und dritter Diode 43 die Außenanschlüsse 343 und 433 aufweisen.

Die Dioden 41, 42 und 43 sind mit ihrer Anode mit ihren jeweiligen Belastungswiderständen 31, 32 bzw. 33 verbunden, während ihre Kathoden über die Außenanschlüsse 431, 432 und 433 gemeinsam mit dem Kollektor eines Transistors 50 verbunden ist. Der Emitter des Transistors 50 ist mit der Masse 7 verbunden. Die Kollektor-Emitter-Strecke wird auch als Laststrecke bezeichnet.

Die Basis des Transistors 50 ist mit einem ersten Anschluss eines zweiten Schaltwiderstands 52 und einem ersten Anschluss eines ersten Schaltwiderstands 51 verbunden. Der zweite Anschluss des zweiten Schaltwiderstands 52 ist mit der Masse 7 und der zweite Anschluss des ersten Schaltwiderstands 51 ist mit einem ersten Anschluss eines Schalters S1 verbunden. Der Schalter S1 ist an seinem zweiten Anschluss mit der Batterie 62 verbunden.

Ist der Schalter S1 geöffnet, wird das Basispotential aufgrund des Stroms durch den Widerstand 52 auf Masse gezogen. Daraufhin sperrt der Transistor 50. Ist der Schalter S1 dagegen geschlossen, liegt das Potential der Basis auf einem Potential, das sich aus der Verhältnis der Schaltwiderstände 51 und 52 ergibt.

Die Widerstände 51 und 52 sind so dimensioniert, dass bei geschlossenem Schalter das Potential der Basis so hoch ist, dass der Transistor 50 sicher leitet, d. h. dass ein Strom zwischen Kollektor und Emitter fließt. Der Transistor 50 bildet einen Schalter, der dafür sorgt, dass die Belastungswiderstände 31, 32 und 33 entweder den ersten Messeingang 201 der zweiten Spannungsmessschaltung 22, den ersten Messeingang 201 der ersten Spannungsmessschaltung 21 und den zweiten Messeingang 202 der zweiten Spannungsmessschaltung 22 mit der Masse 7 verbinden oder dass keine Verbindung über die Belastungswiderstände 31, 32 und 33 mit der Masse vorliegt.

Es versteht sich, dass die Belastungswiderstände 31, 32 und 33 auf andere Weise mit dem festen Potential Masse schaltbar verbunden werden können. Beispielsweise könnten Schalter jeweils zwischen den Belastungswiderständen 31, 32 sowie 33 und den Messeingängen 201 bzw. 202 der Spannungsmessschaltungen 21 und 22 vorgesehen werden.

Die Belastungswiderstände 31, 32 oder 33 können als diskrete Bauelemente realisiert sein, aber können auch beispielsweise durch einen integrierte MOS-Transistoren mit einer hochohmigen Laststrecke implementiert werden.

In Figur 2 sind die Verbindungsleitungen alle fehlerfrei. Dadurch ist im fehlerfreien Zustand, wenn der Schalter S1 geöffnet ist, eine exakte Messung der Spannungen an den Zellen möglich. Die erste Spannungsmessschaltung 21 misst die Spannung $V_{Z1}$, die zwischen dem ersten Anschluss 101 und dem zweiten Anschluss 102 der ersten Zelle 11 anliegt. Die zweite Spannungsmessschaltung 22 misst desgleichen die Spannung $V_{Z2}$, die von der zweiten Zelle 12 zwischen ihren Anschlüssen 101 und 102 bereitgestellt wird.

Dabei ist zu beachten, dass die Widerstände 211 der ersten Messschaltung 21 und der zweiten Messschaltung 22 jeweils einige MOhm aufweisen, während der Innenwiderstand 5 der Zellen 11 und 12 im Bereich von Ohm liegt, beispielsweise 1 Ohm beträgt, und somit das Messergebnis höchstens in der Größenordnung $10^{-6}$ verfälschen kann.

Wird dagegen der Schalter S1 geschlossen, gibt es einen zusätzlichen Pfad von den Eingängen der Spannungsmessschaltung nach Masse.

Der Widerstandswert des Widerstands 5 der ersten 11 bzw. zweiten Zelle 12 wird als $R_i$ bezeichnet, der Widerstandswert der Widerstände 211 der Spannungsmessschaltungen 21 und 22 beträgt $R_h$ und die Belastungswiderstände 31, 32 und 33 haben jeweils Widerstandswerte von $R_n$.

Das Potential an dem Zwischenknoten 103 der ersten Zelle 11 wird als $V_A$ und das Potential an dem zweiten Eingang der ersten Zelle wird als $V_B$ bezeichnet. Die Potentiale sind jeweils auf Masse bei 0V bezogen. Bei geschlossenem Schalter S1 ergibt sich zwischen erstem Messeingang 201 und zweitem Messeingang 202 der ersten Spannungsmessschaltung 21 die folgende Spannung $V_{messZ1}$:

$$V_{messZ1} = \frac{V_B}{1 + \dfrac{R_i}{R_n} + \dfrac{R_i}{R_h}} - V_A \left( \frac{1 + \dfrac{R_i}{R_h}}{1 + \dfrac{R_i}{R_n} + \dfrac{R_i}{R_h}} \right) \qquad \text{Formel 1}$$

Der Wert für den Belastungswiderstand $R_n$ wird zu einigen kOhm bis einigen 10 kOhm gewählt. Wird als Beispiel $R_i$ = 1 Ohm, $R_n$ = 1 kOhm und $R_h$ = 1 MOhm gewählt, so erkennt man, dass die Änderung der Spannung durch den Belastungswiderstand sich im Bereich $10^{-3}$ bewegt. Die erste gemessene Spannung bei geöffnetem Schalter S1 und die zweite gemessene Spannung bei geschlossenem Schalter S1 unterscheiden sich nur in der Größenordnung eines Tausendstels.

Da die Spannungsmessschaltungen 21 und 22 jeweils lediglich eine Statusinformation als Messergebnis ausgeben, bleiben die Ausgaben üblicherweise gleich. Wird bei der ersten Messung eine Normalspannung ausgegeben, so gibt es bei der zweiten Messung in der Regel auch das gleiche Ergebnis. Sind die Messleitungen funktionsfähig, d. h. sehr niederohmig, ändern sich die gemessenen Spannungen und damit auch die Statusausgabe in der Regel nicht.

Sollte die Spannung an der ersten Zelle 11 wirklich so nah an der Über- bzw. Unterspannung sein, dass sich die Statusinformationen von erster zu zweiter Messung ändern, so ist die gemessene Spannung schon so nah an der Ausfallgrenze, dass eine Fehlermeldung auch angebracht ist.

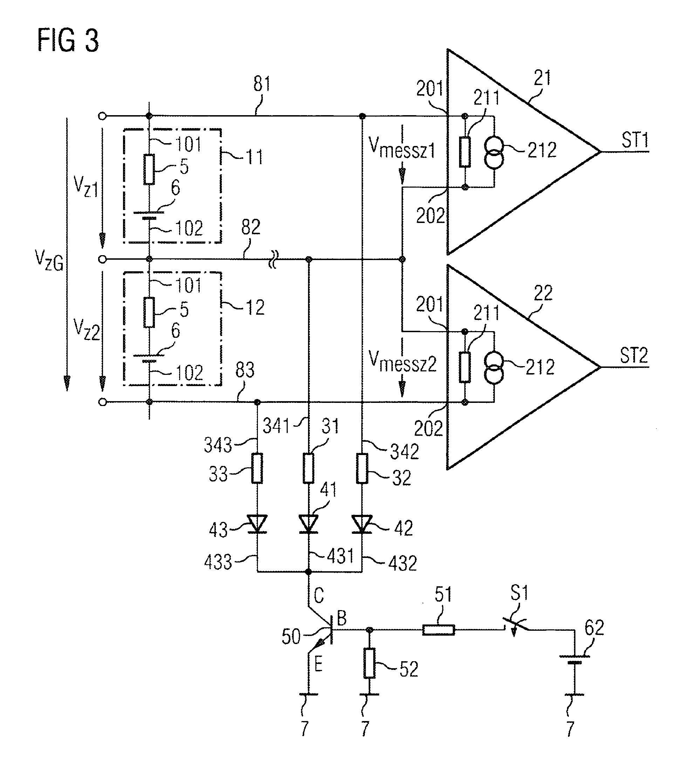

Figur 3 zeigt einen Ausschnitt aus einem Energiespeicher sowie die dazu gehörige Überwachungsschaltung, wobei sich die Figur 3 von der Figur 2 dadurch unterscheidet, dass aufgrund eines Defektes der Verbindungsleitung 82 der zweite Anschluss 102 der ersten Zelle 11 nicht mehr mit dem zweiten Messeingang 202 der ersten Spannungsmessschaltung 21 sowie dem ersten Messeingang 201 der zweiten Spannungsmessschaltung 22 verbunden ist.

Ist eine Verbindungsleitung bzw. sind mehrere Verbindungsleitungen 81, 82, 83 unterbrochen, d. h. hochohmig, ändern sich die gemessenen Spannungen aufgrund des zugeschalteten Belastungsnetzwerks. Ist der Schalter S1 geöffnet, fällt zwischen der Verbindungsleitung 81 und der Verbindungsleitung 83 eine Spannung $V_{ZG}$ ab, die der Summe aus der Spannung $V_{Z1}$ und der Spannung an der zweiten Zelle $V_{Z2}$ entspricht.

Da die Innenwiderstände 211 der Spannungsmessschaltung 21 und 22 gleich sind, fällt an den Spannungsmessschaltungen 21 und 22 jeweils 0,5 . $V_{ZG}$ ab. Ist nun im Fehlerfall eine Verbindungsleitung 82 unterbrochen, werden die Spannungen fehlerhaft gemessen. Dies ist durch die immer vorhandene, wenn auch hochohmige, Eingangsimpedanz der Messschaltungen 21 und 22 bedingt.

Die resultierende gemessene Spannung ist im Fehlerfall bei der ersten Spannungsmessschaltung 21 $V_{messZ1}$ =0,5 · ($V_{Z1}$ + $V_{Z2}$) und die von der zweiten Spannungsmessschaltung 22 gemessene Schaltung beträgt $V_{messZ2}$ = 0,5 · ($V_{Z1}$ + $V_{Z2}$). Es könnte im Fehlerfall durchaus eine Zelle 3 V Zellspannung besitzen und trotzdem würde keine Überspannung angezeigt werden. Während der Überspannungsgrenzwert bei 2,5 V liegt, würde eine Spannung von (3 V + 1 V)/2 = 2 V an den beiden Spannungsmessschaltungen 21 und 22 gemessen. Damit würden beide Messschaltungen aufgrund ihrer eigenen gleichen Termination jeweils nur 2 V messen, obwohl bereits 3 V Zellspannung anliegen.

Bei Batterie- oder Kondensator-Überwachungssystemen wäre dadurch im Fehlerfall des Messleitungsdurchbruchs keine Monitorfunktion der Schaltungsteile möglich. Der Fehler bliebe unentdeckt und das Energiespeichersystem würde schneller verschleißen oder gar zerstört werden. Aus diesem Grund wird erfindungsgemäß bei geöffnetem Schalter S1 nur eine erste Messung durchgeführt, und eine zweite Kontrollmessung bei geschlossenem Schalter S1 durchgeführt.

Das Potential $V_B$ sei das Potential am ersten Eingang 101 der ersten Zelle 11 und das Potential $V_A$ sei das Potential am zweiten Eingang 102 der zweiten Zelle 12. Bei Vernachlässigung der Innenwiderstände 5 der Zellen 11 und 12 ergibt sich für die von der ersten Spannungsmessschaltung 21 gemessenen Spannung $V_{messZ1}$ :

$$V_{messZ1} = U_B - \frac{(V_A + V_B)\dfrac{R_n}{R_h}}{1 + 2 * \dfrac{R_n}{R_h}} \qquad \text{Formel 2}$$

$$V_{messZ2} = -U_A + \frac{(V_A + V_B)\frac{R_n}{R_h}}{1 + 2 * \frac{R_n}{R_h}} \qquad \text{Formel 3}$$

Der Wert $\dfrac{(V_A + V_B)\frac{R_n}{R_h}}{\cdot 1 + 2 * \frac{R_n}{R_h}}$ entspricht dem Potential $V_{ZW}$ an dem ersten Messeingang 201 der zweiten Spannungsmessschaltung 22.

Das Belastungsnetzwerk aus Belastungswiderständen 31,32 und 33, Dioden 41, 42 und 43 und Transistor 50 sollte dabei so niederohmig gewählt sein, dass sich die an der Messschaltung anliegende Spannung im Fehlerfall so signifikant ändert, dass eine Statusänderung bei Zuschalten des Belastungsnetzwerkes auftritt.

Der im Fehlerfalle entstehende hochohmige Spannungsteiler, bedingt durch die Eingangsimpedanzen der Messschaltungen, wird durch das Belastungsnetzwerk zum belasteten Spannungsteiler. Dabei fließt Strom aus den hochohmigen terminierten / floatenden Netzknoten nach Masse bzw. in Ground (GND).

Da in der Regel die Messschaltungen (Spannungsmessung) Widerstände im Bereich > 100 kOhm bis einige Megaohm besitzen, ist ein Widerstandsbereich für das Belastungsnetzwerk von einigen kOhm bis einigen 10 kOhm für das Belastungsnetzwerk sinnvoll bzw. ausreichend, um eine Statusänderung zu bewirken. Der Fehler kann mit dem Belastungsnetzwerk und der resultierenden Statusänderung detektiert werden.

Falls der Wert $R_h$ im Bereich von MOhm und der Wert von $R_n$ im Bereich von kOhm gewählt wird, folgt daraus,

dass dieser Wert $\dfrac{(V_A + V_B)\frac{R_n}{R_h}}{1 + 2 * \frac{R_n}{R_h}}$ aus den Formeln 2 und 3 vernachlässigbar klein gegenüber dem Potential $V_B$ bzw.

$V_A$ ist.

Bei einem Verhältnis von $R_n$ zu $R_h$ von 1 zu 1000 ist das Potential $V_z$ etwa ein Fünfhunderstel des Potentials $V_A$ bzw. des Potentials $V_B$. Sind $V_A$ und $V_B$ nahe 300 V, ist die Spannung am an dem ersten Messeingang 201 der ersten Spannungsmessschaltung 22 nur etwa 0,6 V groß.

Die zweite Spannungsmessschaltung 21 misst bei defekter Verbindungsleitung 81 und bei geschlossenem Schalter S1 eine Spannung, die negativ und somit sicherlich kleiner als die Spannung $V_{Z2}$ ist. Die erste Spannungsmessschaltung misst eine Spannung, die im Wesentlichen dem Potentialunterschied zwischen dem ersten Anschluss 101 der ersten Zelle 11 und der Masse entspricht. Diese Spannung VmessZ1 ist größer als die bei der ersten Messung festgestellten $0,5 \cdot (V_{Z1} + V_{Z2})$. Es gilt somit: $V_{messZ1} > 0.5* (V_{z1}+V_{z2})$ ; $V_{messZ2} < 0.5* (V_{z1}+V_{z2})$.

Die erste Spannungsmessschaltung 21 gibt als Statusinformation ST1 eine Überspannung und die zweite Spannungsmessschaltung 22 meldet als Statusinformation ST2 eine Unterspannung, während bei der ersten Messung von beiden Spannungsmessschaltungen 21 und 22 Normalspannung ausgegeben wurde. Aufgrund dieses Unterschiedes zwischen erster und zweiter Messung kann erkannt werden, dass die Verbindungsleitung 82 gebrochen ist.

Damit der Innenwiderstand $R_i$ bei der Berechnung vernachlässigt werden kann, wird der Widerstand $R_n$ geeignet gewählt. Wird er dieser beispielsweise zu 10 kOhm gewählt, so wird sichergestellt, dass an den Innenwiderständen keine zu große Spannung abfällt. Zudem sorgt ein $R_n$ Wert, der groß genug ist, dafür, dass bei der zweiten Messung nicht zu viel Strom verbraucht wird.

Das Messverfahren lässt sich folgendermaßen zusammenfassen: Durch gezieltes (ggf. zyklisches) Zuschalten eines aus der Sicht der Messschaltung "niederohmigen", z. B. 10 kOhm, Belastungsnetzwerkes werden die Messleitungen unsymmetrisch gegen Masse (GND) belastet.

Das Belastungsnetzwerk wird mittels des Schalters S1 zur Diagnose in den hochohmigen Messpfad geschaltet, dabei wird eine Spannungsänderung und letztlich eine Statusänderung im Fehlerfall bewirkt. Ändert sich also beim Zuschalten, d. h. Schließen von S1, das Statussignal, dann liegt ein Leitungsbruch vor. Bleibt der Status jedoch unverändert, sind die Messleitungen niederohmig an die Zellen angebunden und es liegt somit kein Leitungsbruch vor. Über ein Signal "Diag_EN" wird der Schalter S1 aktiviert. Das Signal kann über eine separate Enable-Leitung aber auch alternativ über die Schnittstellenleitung an S1 weitergeleitet werden.

**Patentansprüche**

1. Überwachungsschaltung für einen Energiespeicher, wobei der Energiespeicher eine Vielzahl von Zellen (1, 11, 12) aufweist, die jeweils einen ersten (101) und einen zweiten Anschluss (102) aufweisen, die jeweils eine Spannung zwischen ihrem ersten (101) und zweiten Anschluss (102) bereitstellen und die in Reihe geschaltet sind, wobei jeweils ein zweiter Anschluss (102) einer ersten Zelle (11) mit einem ersten Anschluss (101) einer zweiten Zelle (12) verbunden ist, wobei die Überwachungsschaltung Folgendes aufweist:

   - mindestens zwei Spannungsmessschaltungen (21, 22), wobei die Spannungsmessschaltungen (21, 22) jeweils die Spannung ($V_{messZ1}$, $V_{messZ2}$) zwischen einem ersten Messeingang (201) und einem zweiten Messeingang (202) der Spannungsmessschaltungen (21, 22) messen, wobei der zweite Messeingang (202) einer ersten Spannungsmessschaltung (21) mit dem ersten Messeingang (201) einer zweiten Spannungsmessschaltung (22) verbunden ist,
   - eine erste Verbindungsleitung (81) zur Verbindung des ersten Anschlusses (101) der ersten Zelle (11) mit dem ersten Messeingang (201) einer ersten Spannungsmessschaltung (21),
   - eine zweite Verbindungsleitung (82) zur Verbindung des zweiten Anschlusses (102) der ersten Zelle (11) mit dem zweiten Messeingang (202) der ersten Spannungsmessschaltung (21),
   - ein erster Belastungswiderstand (31), der schaltbar zwischen dem zweiten Messeingang (202) der ersten Spannungsmessschaltung (21) und einem ersten festen Potential (7) vorgesehen ist.

2. Überwachungsschaltung nach Anspruch 1,
   **dadurch gekennzeichnet, dass** ein zweiter Belastungswiderstand (32) schaltbar zwischen dem ersten Messeingang (201) der ersten Spannungsmessschaltung (21) und einem zweiten festen Potential (7) vorgesehen ist.

3. Überwachungsschaltung nach Anspruch 2,
   **dadurch gekennzeichnet, dass** die Spannungsmessschaltungen (21, 22) einen Innenwiderstand (211) zwischen den beiden Messeingängen (201, 202) mit einem ohmschen Widerstandswert $R_h$ aufweisen und der erste Belastungswiderstand (31) und der zweite Belastungswiderstand (32) jeweils einen ohmschen Widerstandswert $R_n$ haben, wobei gilt: $R_n < R_h$.

4. Überwachungsschaltung nach Anspruch 3,
   **dadurch gekennzeichnet, dass** $R_n < 10 \cdot R_h$ gilt.

5. Überwachungsschaltung nach Anspruch 1, 2, 3 oder 4,
   **dadurch gekennzeichnet, dass** der erste Belastungswiderstand (31) und der zweite Belastungswiderstand (32) jeweils mit einer Diode (41, 42) in Reihe geschaltet sind, und die Reihenschaltungen aus Belastungswiderstand (31, 32) und Diode (41, 42) jeweils einen ersten (341, 342) und einen zweiten (431, 432) Außenanschluss aufweisen, wobei ein Transistor vorgesehen ist, der eine Laststrecke mit einem ersten Anschluss (C) und einem zweiten Anschluss (E) aufweist, wobei der erste Anschluss (C) der Laststrecke mit dem festen Potential (7) verbunden ist und der zweite Anschluss (E) der Laststrecke mit den zweiten Außenanschlüssen (431, 432) der Reihenschaltungen aus Belastungswiderstand und Diode verbunden ist.

6. Überwachungsschaltung nach einem der Ansprüche 1 bis 5,
   **dadurch gekennzeichnet, dass** ein Schalter (50) vorgesehen ist, der in Reihe mit dem ersten Belastungswiderstand (31) geschaltet ist, wobei die Reihenschaltung (50, 31) und der erste Belastungswiderstand (31) zwischen den ersten Messeingang (201) der Spannungsmessschaltung (21) und das feste Potential (7) geschaltet ist, wobei der Schalter (50) zyklisch angeschaltet und ausgeschaltet wird.

7. Überwachungsschaltung nach einem der Ansprüche 1 bis 6,
   **dadurch gekennzeichnet, dass** die Zellen (1, 11, 12) als wieder aufladbare Akkumulatoren ausgebildet sind.

8. Überwachungsschaltung nach einem der Ansprüche 1 bis 7,
   **dadurch gekennzeichnet, dass** die Zellen (1, 11, 12) als Kondensatoren ausgebildet sind.

9. Überwachungsschaltung nach einem der Ansprüche 2 bis 8,

**dadurch gekennzeichnet, dass** das erste feste Potential (7) und das zweite feste Potential (7) auf gleichem Potential liegen.

10. Überwachungsschaltung nach einem der Ansprüche 1 bis 9,
**dadurch gekennzeichnet, dass** das erste feste Potential (7) auf Masse liegt.

11. Überwachungsschaltung nach einem der Ansprüche 1 bis 10,
**dadurch gekennzeichnet, dass** weiter vorgesehen sind:

- eine dritte Verbindungsleitung (83) zur Verbindung des zweiten Anschlusses (102) der zweiten Zelle (12) mit dem zweiten Messeingang (202) der zweiten Spannungsmessschaltung (22),
- ein dritter Belastungswiderstand (33) zur schaltbaren Verbindung zwischen dem zweiten Messeingang (202) der zweiten Spannungsmessschaltung (22) und einem festen Potential (7).

12. Verfahren zur Überwachung eines Energiespeichers, wobei der Energiespeicher eine Vielzahl von Zellen (1, 11, 12) aufweist, die jeweils einen ersten (101) und einen zweiten Anschluss (102) aufweisen, die jeweils eine Spannung ($V_{Z1}$) zwischen ihrem ersten (101) und zweiten (102) Anschluss bereitstellen und die in Reihe geschaltet sind, wobei jeweils ein zweiter Anschluss (102) einer ersten Zelle (11) mit einem ersten Anschluss (101) einer zweiten Zelle (12) verbunden ist,
und wobei das Verfahren folgende Schritte aufweist:

a) Bereitstellen einer Überwachungsschaltung nach einem der Ansprüche 1 bis 11,
b) Schalten des ersten Belastungswiderstands (31) derart, dass der erste Belastungswiderstand (31) keine Verbindung zwischen dem zweiten Messeingang (202) der ersten Spannungsmessschaltung (21) und dem ersten festen Potential (7) bildet,
c) Messen der Spannung ($V_{messZ1}$) an den Messeingängen (201, 202) der ersten Spannungsmessschaltung (21),
d) Schalten des ersten Belastungswiderstands (31) derart, dass der ersten Belastungswiderstand (31) eine Verbindung zwischen dem zweiten Messeingang (201) der ersten Spannungsmessschaltung (21) und dem ersten festen Potential (7) bildet,
e) Messen der Spannung ($V_{messZ1}$) an den Messeingängen der ersten Spannungsmessschaltung (21),
f) Vergleichen der Messung in Schritt c) mit der Messung in Schritt e).

13. Verfahren nach Anspruch 12,
**dadurch gekennzeichnet, dass**

- im Schritt a) eine Überwachungsschaltung vorgesehen wird, bei der ein zweiter Belastungswiderstand (32) schaltbar zwischen dem erste Messeingang (201) der ersten Spannungsmessschaltung (21) und einem zweiten festen Potential (7) vorgesehen ist,
- bei Schritt c) ein zusätzlicher Schritt des Schaltens des zweiten Belastungswiderstands (32) derart, dass der zweite Belastungswiderstand (32) keine Verbindung zwischen dem ersten Messeingang (201) der ersten Spannungsmessschaltung (21) und dem zweiten festen Potential (7) bildet,
- und bei Schritt e) ein zusätzlicher Schritt des Schaltens des zweiten Belastungswiderstands (32) derart, dass der zweite Belastungswiderstand (32) eine Verbindung zwischen dem ersten Messeingang (201) der ersten Spannungsmessschaltung (21) und dem zweiten festen Potential (7) bildet,

vorgesehen ist.

14. Verfahren nach Anspruch 12 oder 13,
**dadurch gekennzeichnet, dass** bei dem Messen in Schritt c) und dem Messen in Schritt e) jeweils eine Statusinformation (ST1) ausgegeben wird, wobei die Statusinformation (ST1) besagt, ob Unterspannung, Überspannung oder Normalspannung vorliegt, und
dass in Schritt f) die in Schritt c) ausgegebene Statusinformation (ST1) mit der in Schritt e) ausgegebenen Statusinformation (ST1) verglichen wird.

**Claims**

1. Monitoring circuit for an energy store, wherein the energy store has a plurality of cells (1, 11, 12) which each have a first (101) and a second terminal (102), which each provide a voltage between their first (101) and second terminal (102), and which are connected in series, with a second terminal (102) of a first cell (11) being connected to a first terminal (101) of a second cell (12) in each case, wherein the monitoring circuit has the following:

   - at least two voltage-measuring circuits (21, 22), with the voltage-measuring circuits (21, 22) each measuring the Voltage ($V_{messZ1}$, $V_{messZ2}$) between a first measuring input (201) and a second measuring input (202) of the voltage-measuring circuits (21, 22), with the second measuring input (202) of a first voltage-measuring circuit (21) being connected to the first measuring input (201) of a second voltage-measuring circuit (22),
   - a first connecting lead (81) for connecting the first terminal (101) of the first cell (11) to the first measuring input (201) of a first voltage-measuring circuit (21),
   - a second connecting lead (82) for connecting the second terminal (102) of the first cell (11) to the second measuring input (202) of the first voltage-measuring circuit (21), and
   - a first loading resistor (31) which is provided so as to be switchable between the second measuring input (202) of the first voltage-measuring circuit (21) and a first fixed potential (7).

2. Monitoring circuit according to claim 1,
   **characterised in that**
   a second loading resistor (32) is provided which is switchable between the first measuring input (201) of the first voltage-measuring circuit (21) and a second fixed potential (7).

3. Monitoring circuit according to claim 2,
   **characterised in that**
   the voltage-measuring circuits (21, 22) have an internal resistor (211) between the two measuring inputs (201, 202) which has an ohmic resistance value $R_h$ and the first loading resistor (31) and the second loading resistor (32) each have an ohmic resistance value $R_n$, where $R_n < R_h$.

4. Monitoring circuit according to claim 3,
   **characterised in that**
   $R_n < 10 \cdot R_h$.

5. Monitoring circuit according to claim 1, 2, 3 or 4,
   **characterised in that**
   the first loading resistor (31) and the second loading resistor (32) are each connected in series with a diode (41, 42), and the series circuits formed from loading resistor (31, 32) and diode (41, 42) each have a first (341, 342) and a second (431, 432) external terminal,
   wherein a transistor (50) is provided which has a load path with a first terminal (C) and a second terminal (E), with the first terminal (C) of the load path being connected to the fixed potential (7) and the second terminal (E) of the load path being connected to the second external terminals (431, 432) of the series circuits formed from loading resistor and diode.

6. Monitoring circuit according to one of claims 1 to 5,
   **characterised in that**
   a switch (50) is provided which is connected in series with the first loading resistor (31), wherein the series circuit (50, 31) and the first loading resistor (31) are connected between the first measuring input (201) of the voltage-measuring circuit (21) and the fixed potential (7), with the switch (50) being switched on and off cyclically.

7. Monitoring circuit according to one of claims 1 to 6,
   **characterised in that**
   the cells (1, 11, 12) are embodied as rechargeable batteries.

8. Monitoring circuit according to one of claims 1 to 7,
   **characterised in that**
   the cells (1, 11, 12) are embodied as capacitors.

9. Monitoring circuit according to one of claims 2 to 8,

**characterised in that**
the first fixed potential (7) and the second fixed potential (7) are at the same potential.

10. Monitoring circuit according to one of claims 1 to 9,
    **characterised in that**
    the first fixed potential (7) is connected to ground.

11. Monitoring circuit according to one of claims 1 to 10,
    **characterised in that**
    further provided are:

    - a third connecting lead (83) for connecting the second terminal (102) of the second cell (12) to the second measuring input (202) of the second voltage-measuring circuit (22),
    - a third loading resistor (33) for a connection which can be switched between the second measuring input (202) of the second voltage-measuring circuit (22) and a fixed potential (7) .

12. Method for monitoring an energy store, wherein the energy store has a plurality of cells (1, 11, 12) which each have a first (101) and a second terminal (102), which each provide a voltage ($V_{Z1}$) between their first (101) and second terminal (102), and which are connected in series, with a second terminal (102) of a first cell (11) being connected to a first terminal (101) of a second cell (12) in each case,
    and wherein the method has the following steps of:

    a) providing a monitoring circuit according to one of claims 1 to 11,
    b) switching the first loading resistor (31) in such a way that the first loading resistor (31) does not form a connection between the second measuring input (202) of the first voltage-measuring circuit (21) and the first fixed potential (7),
    c) measuring the voltage ($V_{messZ1}$) at the measuring inputs (201, 202) of the first voltage-measuring circuit (21),
    d) switching the first loading resistor (31) in such a way that the first loading resistor (31) forms a connection between the second measuring input (201) of the first voltage-measuring circuit (21) and the first fixed potential (7),
    e) measuring the voltage ($V_{messZ1}$) at the measuring inputs of the first voltage-measuring circuit (21), and
    f) comparing the measurement at step c) with the measurement at step e).

13. Method according to claim 12,
    **characterised in that**

    - at step a) a monitoring circuit is provided in which a second loading resistor (32) is provided so as to be switched between the first measuring input (201) of the first voltage-measuring circuit (21) and a second fixed potential (7),
    - at step c) an additional step is provided at which the second loading resistor (32) is switched in such a way that the second loading resistor (32) does not form a connection between the first measuring input (201) of the first voltage-measuring circuit (21) and the second fixed potential (7), and
    - at step e) an additional step is provided at which the second loading resistor (32) is switched in such a way that the second loading resistor (32) forms a connection between the first measuring input (201) of the first voltage-measuring circuit (21) and the second fixed potential (7).

14. Method according to claim 12 or 13,
    **characterised in that**
    status information (ST1) is output in each case during measuring at step c) and during measuring at step e), with the status information (ST1) indicating whether undervoltage, overvoltage or normal voltage is present, and
    **in that** at step f) the status information (ST1) output at step c) is compared with the status information (ST1) output at step e).

**Revendications**

1. Circuit de contrôle pour un accumulateur d'énergie, dans lequel l'accumulateur d'énergie présente une pluralité d'éléments (1, 11, 12), qui présentent respectivement une première connexion (101) et une seconde connexion (102), qui établissent respectivement une tension entre leur première connexion (101) et leur seconde connexion (102) et qui sont montées en série, où respectivement une seconde connexion (102) d'un premier élément (11) est connectée à une première connexion (101) d'un deuxième élément (12), le circuit de contrôle comportant ce qui suit :

- au moins deux circuits de mesure de tension (21, 22), où les circuits de mesure de tension (21, 22) mesurent respectivement la tension ($V_{messZ1}$; $V_{messZ2}$) entre une première entrée de mesure (201) et une seconde entrée de mesure (202) des circuits de mesure de tension (21, 22), où la seconde entrée de mesure (202) d'un premier circuit de mesure de tension (21) est connectée à la première entrée de mesure (201) d'un second circuit de mesure de tension (22),
- une première ligne de connexion (81) pour connecter la première connexion (101) du premier élément (11) à la première entrée de mesure (201) d'un premier circuit de mesure de tension (21),
- une deuxième ligne de connexion (82) pour connecter la seconde connexion (102) du premier élément (11) à la seconde entrée de mesure (202) du premier circuit de mesure de tension (21), et
- une première résistance ballast (31), qui est prévue pour être montée entre la seconde entrée de mesure (202) du premier circuit de mesure de tension (21) et un premier potentiel fixe (7).

2. Circuit de contrôle selon la revendication 1,
**caractérisé en ce que**
une deuxième résistance ballast (32) est prévue pour être montée entre la première entrée de mesure (201) du premier circuit de mesure de tension (21) et un second potentiel fixe (7).

3. Circuit de contrôle selon la revendication 2,
**caractérisé en ce que**
les circuits de mesure de tension (21, 22) présentent une résistance interne (211) entre les deux entrées de mesure (201, 202) avec une valeur de résistance ohmique $R_h$ et la première résistance ballast (31) et la deuxième résistance ballast (32) ont respectivement une valeur de résistance ohmique $R_n$, où $R_n < R_h$.

4. Circuit de contrôle selon la revendication 3,
**caractérisé en ce que**
la relation $R_n < 10 \cdot R_h$ s'applique.

5. Circuit de contrôle selon la revendication 1, 2, 3 ou 4,
**caractérisé en ce que**
la première résistance ballast (31) et la deuxième résistance ballast (32) sont montées respectivement en série avec une diode (41, 42) et **en ce que** les circuits en série constitués d'une résistance ballast (31, 32) et d'une diode (41, 42) présentent respectivement une première connexion externe (341, 342) et une seconde connexion externe (431, 432),
dans lequel on prévoit un transistor qui présente un segment de charge avec une première connexion (C) et une seconde connexion (E), dans lequel la première connexion (C) du segment de charge est connectée au premier potentiel fixe (7) et la seconde connexion (E) du segment de charge est connectée aux secondes connexions externes (431, 432) des circuits en série constitués d'une résistance ballast et d'une diode.

6. Circuit de contrôle selon l'une quelconque des revendications 1 à 5,
**caractérisé en ce que**
l'on prévoit un commutateur (50) qui est monté en série avec la première résistance ballast (31), où le circuit en série (50, 31) et la première résistance ballast (31) sont montés entre la première entrée de mesure (201) du circuit de mesure de tension (21) et le potentiel fixe (7), le commutateur (50) étant connecté et déconnecté de manière cyclique.

7. Circuit de contrôle selon l'une quelconque des revendications 1 à 6,
**caractérisé en ce que**
les éléments (1, 11, 12) se présentent sous la forme d'accumulateurs rechargeables.

8. Circuit de contrôle selon l'une quelconque des revendications 1 à 7,
**caractérisé en ce que**
les éléments (1, 11, 12) se présentent sous la forme de condensateurs.

9. Circuit de contrôle selon l'une quelconque des revendications 2 à 8,

**caractérisé en ce que**
le premier potentiel fixe (7) et le second potentiel fixe (7) se trouvent au même potentiel.

10. Circuit de contrôle selon l'une quelconque des revendications 1 à 9,
**caractérisé en ce que**
le premier potentiel fixe (7) est relié à la terre.

11. Circuit de contrôle selon l'une quelconque des revendications 1 à 10,
**caractérisé en ce que** l'on prévoit encore :

- une troisième ligne de connexion (83) pour connecter la seconde connexion (102) du second élément (12) à la seconde entrée de mesure (202) du second circuit de mesure de tension (22),
- une troisième résistance ballast (33) pour une connexion commutable entre la seconde entrée de mesure (202) du second circuit de mesure de tension (22) et un potentiel fixe (7).

12. Procédé de contrôle d'un accumulateur d'énergie, dans lequel l'accumulateur d'énergie comporte une pluralité d'éléments (1, 11, 12), qui présentent respectivement une première connexion (101) et une seconde connexion (102), qui établissent respectivement une tension ($V_{Z1}$) entre leur première connexion (101) et leur seconde connexion (102) et qui sont montées en série, où respectivement une seconde connexion (102) d'un premier élément (11) est connecté à une première connexion (101) d'un second élément (12),
et dans lequel le procédé comporte les étapes suivantes :

a) la mise en place d'un circuit de contrôle selon l'une quelconque des revendications 1 à 11,
b) le montage de la première résistance ballast (31) de sorte que la première résistance ballast (31) ne forme aucune connexion entre la seconde entrée de mesure (202) du premier circuit de mesure de tension (21) et le premier potentiel fixe (7),
c) la mesure de la tension ($V_{messZ1}$) aux entrées de mesure (201, 202) du premier circuit de mesure de tension (21),
d) le montage de la première résistance ballast (31) de sorte que la première résistance ballast (31) forme une connexion entre la seconde entrée de mesure (201) du premier circuit de mesure de tension (21) et le premier potentiel fixe (7),
e) la mesure de la tension ($V_{messZ1}$) aux entrées de mesure du premier circuit de mesure de tension (21), et
f) la comparaison de la mesure de l'étape c) avec la mesure de l'étape e).

13. Procédé selon la revendication 12,
**caractérisé en ce que**

- à l'étape a), on prévoit un circuit de contrôle, dans lequel on prévoit une deuxième résistance ballast (32) qui peut être montée entre la première entrée de mesure (201) du premier circuit de mesure de tension (21) et le second potentiel fixe (7),
- à l'étape c), on prévoit une étape supplémentaire du montage de la deuxième résistance ballast (32) de sorte que la deuxième résistance ballast (32) ne forme pas de connexion entre la première entrée de mesure (201) dupremier circuit de mesure de tension (21) et le second potentiel fixe (7),
- et à l'étape e), on prévoit une étape supplémentaire du montage de la deuxième résistance ballast (32) de sorte que la deuxième résistance ballast (32) forme une connexion entre la première entrée de mesure (201) du premier circuit de mesure de tension (21) et le second potentiel fixe (7).

14. Procédé selon la revendication 12 ou 13,
**caractérisé en ce que**,
lors de la mesure de l'étape c) et de la mesure de l'étape e), une information d'état (ST1) est respectivement délivrée, l'information d'état (ST1) indiquant si l'on se trouve en sous-tension, en surtension ou en tension normale et **en ce qu'**à l'étape f), l'information d'état (ST1) délivrée à l'étape c) est comparée à l'information d'état (ST1) délivrée à l'étape e).

## FIG 1

# FIG 2

EP 2 225 572 B1

# FIG 3

16

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20020047685 A1
- US 6329792 B1